# EUROPEAN PATENT APPLICATION

(11) **EP 4 580 050 A1**
(43) Date of publication of application: **02.07.2025**
(21) Application number: 24189484.9
(22) Date of filing: 18.07.2024
(51) Int. Cl.: H03F 1/02, H03F 1/56, H03F 3/195, H03F 3/21, H03F 3/24

(54) **RADIO FREQUENCY POWER AMPLIFYING CHIP, RADIO FREQUENCY POWER AMPLIFIER, AND WIRELESS SIGNAL TRANSMITTING SYSTEM**

(30) Priority: 29.12.2023 CN 202311851007
(71) Applicant: Suzhou Watech Electronics Co., Ltd., Suzhou, Jiangsu 215125 (CN)
(72) Inventor: LIU, Haoyu, Suzhou, Jiangsu, 215125 (CN); CHEN, Yali, Suzhou, Jiangsu, 215125 (CN)
(74) Representative: Michalski Hüttermann & Partner Patentanwälte mbB

(57) **Abstract**

Disclosed are a radio frequency power amplifying chip, a radio frequency power amplifier, and a wireless signal transmitting system. The radio frequency power amplifying chip includes a first amplifying branch, a second amplifying branch, and a combined output circuit comprising: a first inductor having a first end connected to an output port of the first amplifying branch; a second inductor having a first end connected to an output port of the second amplifying branch; a third inductor having a first end connected to a second end of the second inductor; a first capacitor having a first end connected between a second end of the second capacitor and the first end of the third capacitor; and a fourth inductor having a first end connected to the first end of the first capacitor, and a second end connected to the drain voltage bias circuit of the radio frequency power amplifier.

## Description

### TECHNICAL FIELD

The present disclosure relates to the radio technical field, more particularly to a radio frequency power amplifying chip, a radio frequency power amplifier, and a wireless signal transmitting system.

### BACKGROUND

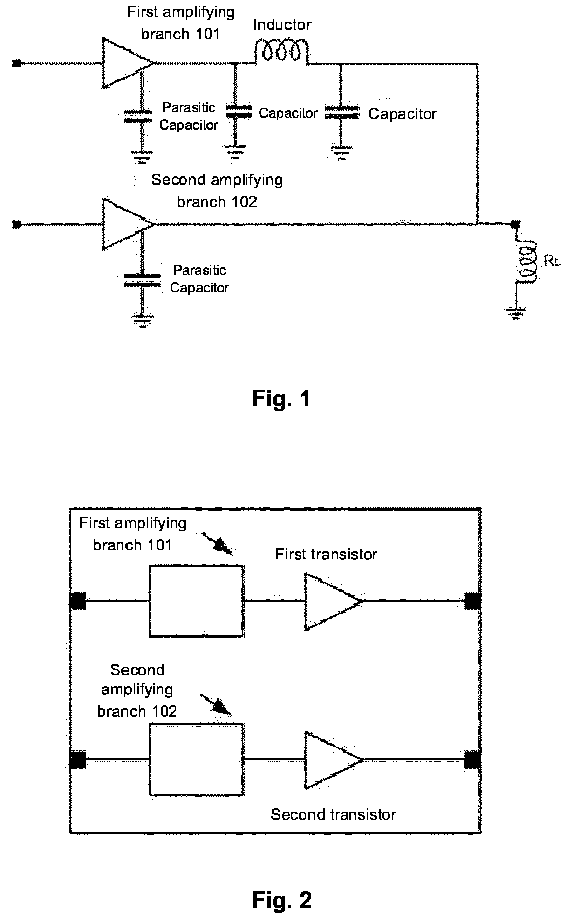

Radio frequency (RF) power amplifier is one of the most important components in radio frequency front-end systems and has been widely used in conventional communication systems. In order to meet the requirements of high power, high efficiency, and miniaturization, as shown in Fig. 1, Fig. 1 is a simplified schematic circuit diagram of a radio frequency power amplifier in the prior art. The radio frequency power amplifier comprises two transistor amplifiers packaged on the same carrier in parallel, and with an appropriate combined circuit network, the radio frequency power amplifier can realize high-efficiency operation from the fallback power state to the saturated power state. As shown in Fig. 2, Fig. 2 is a simplified block diagram of the radio frequency power amplifying chip of Fig. 1.

As can be seen from Figs. 1 and 2, the radio frequency output ports of the first amplifying branch 101 and the second amplifying branch 102 are connected to a power-combining network composed of capacitors and inductors, and the two-port network composed of these capacitors and inductors is equivalent to a transmission line with a characteristic impedance of ZM and an electrical length of 90° in the operating frequency band. The main problems of the conventional architecture are low efficiency and narrow bandwidth, which makes it difficult to meet the requirements of low energy consumption, large bandwidth, and high throughput of the current mobile communication system.

### SUMMARY

In order to solve one of the above technical defects, the embodiment of the present disclosure provides a radio frequency power amplifying chip, a radio frequency power amplifier, and a wireless signal transmitting system. The technical proposal is as follows:

According to the first aspect of the embodiments of the present disclosure, the present disclosure provides a radio frequency power amplifying chip, for a radio frequency power amplifier for amplifying a signal. The radio frequency power amplifying chip comprises a first amplifying branch and a second amplifying branch. An input port of the first amplifying branch and an input port of the second amplifying branch are configured to receive a radio frequency signal. The radio frequency power amplifying chip further comprises a combined output circuit comprising:

a first inductor, having a first end connected to an output port of the first amplifying branch and a second end connected to the output impedance matching circuit of the radio frequency power amplifier; a second inductor, having a first end connected to an output port of the second amplifying branch; a third inductor, having a first end connected to a second end of the second inductor and a second end connected to the output impedance matching circuit of the radio frequency power amplifier; a first capacitor, having a first end connected between the second end of the second capacitor and the first end of the third capacitor and a second end grounded; and a fourth inductor, having a first end connected to the first end of the first capacitor and a second end connected to the drain voltage bias circuit of the radio frequency power amplifier.

According to a second aspect of the embodiment of the present disclosure, the present disclosure provides a radio frequency power amplifier comprising:

the radio frequency power amplifying chip; a first input impedance matching circuit, one end of the first input impedance matching circuit connected to the input port of the first amplifying branch of the radio frequency power amplifying chip, and the other end connected to a radio frequency output device; a second input impedance matching circuit, one end of the second input impedance matching circuit connected to the input port of the second amplifying branch of the radio frequency power amplifying chip, and the other end connected to the device output device; an output impedance matching circuit, one end of the output impedance matching circuit connected to the combined output circuit of the radio frequency power amplifying chip, and the other end connected to a signal transmitting device; a drain voltage bias circuit, one end of the drain voltage bias circuit connected to the fourth inductor of the combined output circuit, and the other end connected to the third power supply.

According to a third aspect of the embodiments of the present disclosure, the present disclosure provides a wireless signal transmitting system comprising:

a radio frequency output equipment, a signal transmitting device, and the radio frequency power amplifier respectively connected to the radio frequency output device and the signal transmitting device.

By adopting the radio frequency power amplifying chip provided in the embodiment of the present disclosure, the combined output circuit is inside the package of the radio frequency power amplifying chip, and the amplified signals are combined and then connected to the external output impedance matching circuit through the pins, so that the parasitic characteristics of the package pins greatly reduce the impact on bandwidth and efficiency, and the radio frequency signal on the drain voltage bias circuit is very small, so that the impact of the corresponding pins on efficiency is almost negligible, thereby improving the efficiency and bandwidth of the radio frequency power amplifier.

### BRIEF DESCRIPTION OF THE DRAWINGS

The accompanying drawings described herein are used to provide further understanding of the disclosure and form part of the disclosure, and the illustrative embodiments of this disclosure and their explanations are used to explain the disclosure and do not constitute an undue qualification of the disclosure. In the drawings:
Fig. 1 is a simplified circuit schematic diagram of a radio frequency power amplifier of the prior art.
Fig. 2 is a simplified block diagram of the radio frequency power amplifying chip of Fig. 1.
Fig. 3 is a block diagram of the radio frequency power amplifying chip according to the present disclosure.
Fig. 4 is a circuit schematic diagram of the radio frequency power amplifying chip according to the present disclosure.
Fig. 5 is a schematic diagram of the equivalent circuit of Fig. 4.
Fig. 6 is another circuit schematic diagram of the radio frequency power amplifying chip according to the present disclosure.
Fig. 7 is a schematic diagram of the equivalent circuit of Fig. 6.
Fig. 8 is yet another circuit schematic diagram of the radio frequency power amplifying chip according to the present disclosure.
Fig. 9 is a schematic diagram of the equivalent circuit of Fig. 8.
Fig. 10 is a structural block diagram of the radio frequency power amplifier according to the present disclosure.
Fig. 11 is a circuit schematic diagram of the radio frequency power amplifier according to the present disclosure.
Fig. 12 is an experimental comparison diagram between the technical proposal of the present disclosure and the proposal of the prior art.
Fig. 13 is another experimental comparison diagram between the technical proposal of the present disclosure and the proposal of the prior art.
Fig. 14 is yet another experimental comparison diagram between the technical proposal of the present disclosure and the proposal of the prior art.

### DETAILED DESCRIPTION OF THE EMBODIMENTS

In order to make the technical proposal and advantages of the embodiments of the present disclosure clearer, the following exemplary embodiments of the present disclosure will be described in further detail in conjunction with the accompanying drawings. Obviously, the described embodiments are only a part of the embodiments of the present disclosure, not an exhaustive list of all embodiments. It should be noted that the embodiments of the present disclosure and the features of the embodiments can be combined with each other without conflict.

In the description of the present disclosure, it is to be understood that the terms "first", "second", "third", etc. are for descriptive purposes only, and cannot be understood as indicating or implying relative importance or implying the number of indicated technical features. Thus, the features defined as "first", "second", "third" and the like can expressly or implicitly comprise one or more of the features. In the description of this disclosure, "a plurality of" means at least two, e.g. two, three, etc., unless otherwise expressly and specifically qualified.

In this disclosure, unless otherwise expressly stipulated and qualified, the terms "connected", "disposed" and other terms should be understood in a broad sense, for example, it can be a fixed connection or a detachable connection. It can be directly connected or indirectly connected through an intermediate medium. For those of ordinary skill in the art, the specific meanings of the above-mentioned terms in this disclosure can be understood on a case-by-case basis.

As one of the core components of wireless signal transmitting systems, the radio frequency power amplifier is increasingly developing towards high power, high efficiency, and miniaturization. As shown in Fig. 1, the conventional radio frequency power amplifier comprises two transistors. With an appropriate combiner circuit network, the radio frequency power amplifier can achieve high-efficiency operation from the fallback power state to the saturated power state.

As can be seen from Figs. 1 and 2, the radio frequency output ports of the first amplifying branch 101 and the second amplifying branch 102 are connected to a power-combining network composed of capacitors and inductors, and the two-port network composed of these capacitors and inductors is equivalent to a transmission line with a characteristic impedance of ZM and an electrical length of 90° in the operating frequency band. That is to say, the conventional radio frequency power amplifiers have the defects of low efficiency and narrow bandwidth, and it has been difficult to meet the needs of low energy consumption, large bandwidth, and high throughput of current mobile communication systems. Moreover, in the prior art, additional peripheral circuits (such as microstrip lines, SMD surface-mounted devices, etc.) are required outside the radio frequency power amplifying chip, which will lead to a large size of the radio frequency power amplifier, which is not conducive to the demand of the miniaturization and integration of the current radio frequency communication system.

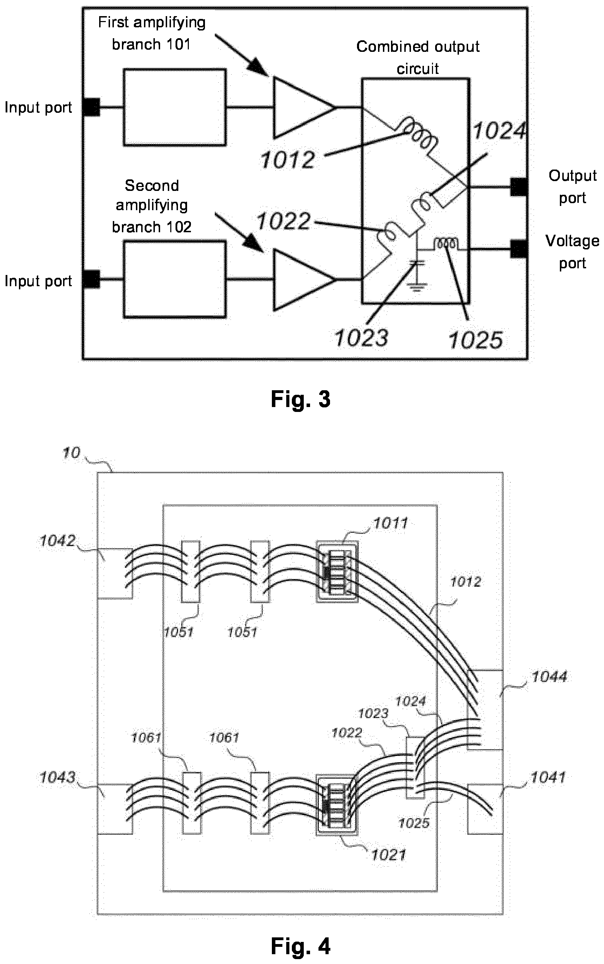

The present disclosure provides a radio frequency power amplifying chip, which is disposed on a radio frequency power amplifier to amplify a radio frequency signal. As shown in Fig. 3, Fig. 3 is a structural block diagram of the radio frequency power amplifying chip. As shown in Fig. 4, Fig. 4 is a circuit schematic diagram of the radio frequency power amplifying chip. The package types of the radio frequency power amplifying chip comprise but are not limited to QFN (Quad Flat No-leads package) and LGA (Land Grid Array package).

The radio frequency power amplifying chip comprises a first amplifying branch 101, a second amplifying branch 102, and a combined output circuit. An input port of the first amplifying branch 101 can be connected to a radio frequency output device to receive a radio frequency signal. An input port of the second amplifying branch 102 can be connected to the radio frequency output device to receive the radio frequency signal. After the radio frequency signal is amplified in the first amplifying branch 101 and the second amplifying branch 102, the radio frequency signal is output from an output port of the first amplifying branch 101 and an output port of the second amplifying branch 102 respectively.

The combined output circuit comprises a first inductor 1012, a second inductor 1022, a third inductor 1024, a fourth inductor 1025, and a first capacitor 1023. The output port of the first amplifying branch 101 is connected to the first end of the first inductor 1012, and the second end of the first inductor 1012 is connected to an output impedance matching circuit of the radio frequency power amplifier. The output port of the second amplifying branch 102 is connected to the first end of the second inductor 1022, the second end of the second inductor 1022 is connected to the first end of the third inductor 1024, the second end of the third inductor 1024 can be connected to the output impedance matching circuit of the radio frequency power amplifier, the first end of the first capacitor 1023 is connected between the second end of the second inductor 1022 and the first end of the third inductor 1024, and the second end of the first capacitor 1023 is grounded. The first end of the fourth inductor 1025 is connected to the first end of the first capacitor 1023, and the second end of the fourth inductor 1025 can be connected to a drain voltage bias circuit of the radio frequency power amplifier. That is, the output port of the second amplifying branch 102, the second inductor 1022, and the third inductor 1024 are sequentially connected in series, one end of the first capacitor 1023 is grounded, and the other end of the first capacitor 1023 is connected between the second inductor 1022 and the third inductor 1024. The second inductor 1022, the first capacitor 1023, and the third inductor 1024 form a T-shaped network. The first end of the fourth inductor 1025 is connected to the first end of the first capacitor 1023, and the second end of the fourth inductor 1025 is connected to the first end of the first capacitor 1023. The second end of the fourth inductor 1025 is connected to the drain voltage bias circuit to supply power to the drain of the transistors in the first amplifying branch 101 and the second amplifying branch 102.

After the first amplifying branch 101 amplifies the signal (i.e., the radio frequency signal), the first amplifying branch 101 transmits the signal to the first inductor 1012 and then transmits the signal to the output impedance matching circuit of the radio frequency power amplifier through the first inductor 1012. After the second amplifying branch 102 amplifies the signal (i.e., the radio frequency signal), the second amplifying branch transmits the amplified signal to the output impedance matching circuit through the second inductor 1022, the first capacitor 1023, and the third inductor 1024.

In the conventional proposal, the output signals of the first amplifying branch and the second amplifying branch are connected to the external combined output circuit through the pins of the radio frequency power amplifying chip, so the pins also become a part of the combined output circuit. Due to the parasitic characteristics of the packaging pins (additional parasitic inductance, parasitic capacitance, and parasitic loss will be introduced), the overall operating bandwidth of the combined output circuit will be reduced. However, in the proposal of the present disclosure, the combined output circuit is inside the package of the radio frequency power amplifying chip, and the amplified signals are combined and then connected to the external output impedance matching circuit through the pins, so that the parasitic characteristics of the package pins greatly reduce the impact on bandwidth and efficiency, and the radio frequency signal on the drain voltage bias circuit is very small, so that the impact of the corresponding pins on efficiency is almost negligible, thereby improving the efficiency and bandwidth of the radio frequency power amplifier.

In one or more embodiments, as shown in Fig. 4, the radio frequency power amplifying chip 10 comprises a fourth pin 1044. The fourth pin 1044 is connected to the second end of the first inductor 1012 and the second end of the third inductor 1024 respectively, and the fourth pin 1044 can also be connected to the output impedance matching circuit of the radio frequency amplifier, that is, the second end of the first inductor 1012 and the second end of the third inductor 1024 are connected to the output impedance matching circuit through the fourth pin 1044.

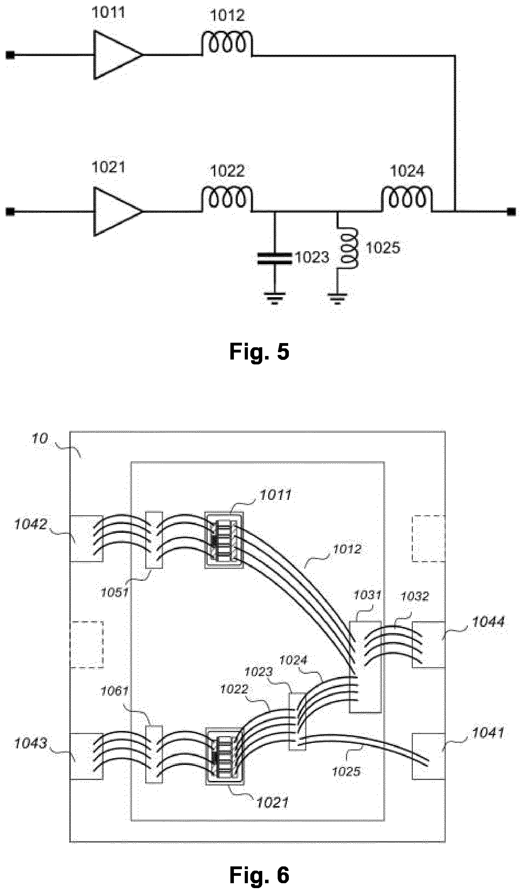

As shown in Fig. 5, Fig. 5 is an equivalent circuit schematic diagram of Fig. 4. The first inductor 1012, the second inductor 1022, the third inductor 1024, and the fourth inductor 1025 in Fig. 4 can be equivalent to a metal bonding wire. The output port of the first amplifying branch 101 is connected to the output impedance matching circuit through the first inductor 1012 (about 0.8 to 2nH, depending on different design scenarios, frequencies, and semiconductor process types), the output port of the second amplifying branch 102 is connected to the output impedance matching circuit through the second inductor 1022 (about 0.2 to 0.8nH), the third inductor 1024 (about 0.2 to 0.8nH), and the first capacitor 1023 (about 3 to 9pF). The fourth inductor 1025 (about 0.5 to 2nH), which is connected to the drain voltage bias circuit of the radio frequency power amplifier, is a radio frequency equivalent short circuit, so it is equivalent to a parallel inductor.

The first inductor 1012, the second inductor 1022, and the third inductor 1024 can all be implemented in the form of metal bonding wires, that is, the output port of the second amplifying branch 102 is connected to the fourth pin 1044 through the metal bonding wire, the first capacitor 1023 is connected to the output port of the second amplifying branch 102 through the metal bonding wire, and the first capacitor 1023 is also connected to the fourth pin 1044 through the metal bonding wire. The metal bonding wire between the first capacitor 1023 and the output port of the first amplifying branch 101 and the metal bonding wire between the first capacitor 1023 and the fourth pin 1044 are in the same direction, thereby reducing the mutual inductive coupling between the respective metal bonding wires and reducing the transmission loss of the radio frequency signal.

In some embodiments, the heights of the metal bonding wires corresponding to the first inductor 1012, the second inductor 1022, and the third inductor 1024 can be 150 microns to 450 microns, i.e., the heights of the metal bonding wires can comprise, but are not limited to, 170 microns, 200 microns, 230 microns, 250 microns, 270 microns, 300 microns, 320 microns, 350 microns, 380 microns, 400 microns, and 420 microns.

As shown in Fig. 6, Fig. 6 is another circuit schematic diagram of the radio frequency power amplifying chip. The radio frequency power amplifying chip 10 can also comprise a second capacitor 1031. The first end of the second capacitor 1031 is connected to the second end of the first inductor 1012, the first end of the second capacitor 1031 is also connected to the second end of the third inductor 1024, and the second end of the second capacitor 1031 is connected to the output impedance matching circuit of the radio frequency power amplifier. That is, the first end of the second capacitor 1031 is connected to the second end of the first inductor 1012 and the second end of the third inductor 1024 respectively, and the second end of the second capacitor 1031 can be connected to the output impedance matching circuit of the radio frequency amplifier.

The second end of the second capacitor 1031 can be connected to the output impedance matching circuit through the fourth pin 1044, that is, the second end of the second capacitor 1031 is connected to one end of the first bonding wire 1032, and the other end of the first bonding wire 1032 is connected to the fourth pin 1044. The amplified signals output by the first amplifying branch 101 and the second amplifying branch 102 are combined on the second capacitor 1031, and the bandwidth of the combined impedance matching can be increased by connecting the first bonding wire 1032 to the fourth pin 1044.

Meanwhile, the length of the first bonding wire 1032 can be 300 microns to 800 microns, such as the length of the first bonding wire 1032 comprising, but not limited to, 330 microns, 350 microns, 370 microns, 400 microns, 500 microns, 600 microns, and 700 microns. The fourth inductor 1025 is a metal bonding wire, the length of the fourth inductor 1025 can be 500 microns to 2000 microns, and the length of the fourth inductor 1025 can comprise, but is not limited to, 550 microns, 650 microns, 720 microns, 750 microns, 770 microns, 800 microns, 920 microns, 1100 microns, 1300 microns, 1400 microns, and 1800 microns.

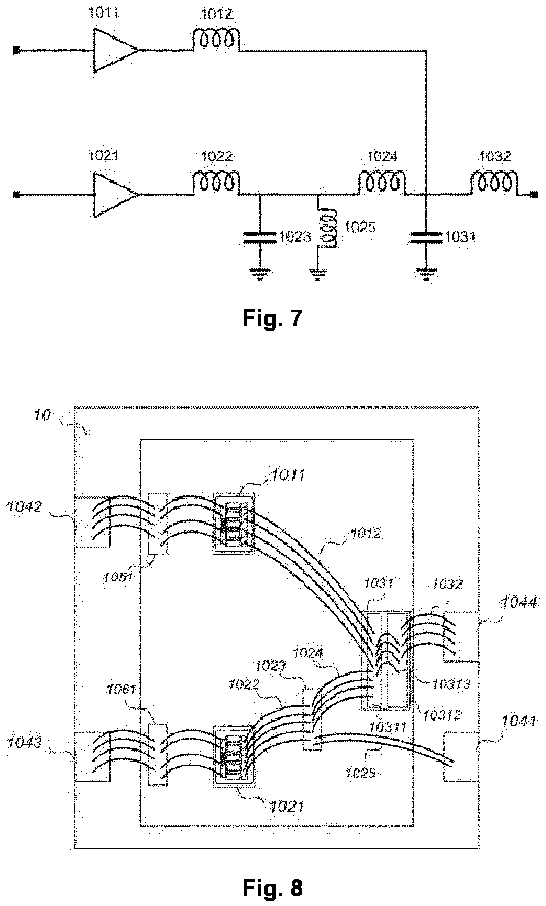

As shown in Fig. 7, Fig. 7 is an equivalent circuit schematic diagram of Fig. 6. Different from Fig. 5, an inductor (about 0.2 to 0.8nH, depending on different design scenarios, frequencies, and semiconductor process types) corresponding to the first bonding wire 1032 and a second capacitor 1031 (about 4 to 8pF) are added in Fig. 7, and the rest are the same as Fig. 5 and will not be repeated here.

In one or more embodiments, as shown in Fig. 8, Fig. 8 is yet another schematic diagram of the radio frequency power amplifying chip. The second capacitor 1031 can comprise a double-splicing capacitor comprising a first sub-capacitor 10311 and a second sub-capacitor 10312. The first end of the first sub-capacitor 10311 is connected to the second end of the first inductor 1012 and the second end of the third inductor 1024 respectively, and the second end of the first sub-capacitor 10311 is connected to the first end of the second sub-capacitor 10312, and the second end of the second sub-capacitor 10312 can be connected to the output impedance matching circuit of the radio frequency power amplifier. The first sub-capacitor 10311 can be connected to the second sub-capacitor 10312 through the second bonding wire 10313.

The second end of the second sub-capacitor 10312 can be connected to the output impedance matching circuit through the fourth pin 1044, that is, the second end of the second sub-capacitor 10312 is connected to one end of the first bonding wire 1032, and the other end of the first bonding wire 1032 is connected to the fourth pin 1044. The double-splicing capacitor comprises two capacitive upper plates connected by a second bonding wire 10313 and connected to the fourth pin 1044 by the first bonding wire 1032, thereby further increasing the bandwidth of the combined impedance matching.

Meanwhile, the length of the second bonding wire 10313 can be from 200 microns to 600 microns, such as the length of the second bonding wire 10313 comprises, but not limited to, 230 microns, 250 microns, 270 microns, 300 microns, 320 microns, 350 microns, and 370 microns. The length of the first bonding wire 1032 can be 300 microns to 800 microns, such as the length of the first bonding wire 1032 comprises, but not limited to, 330 microns, 350 microns, 370 microns, 400 microns, 500 microns, 600 microns, and 700 microns.

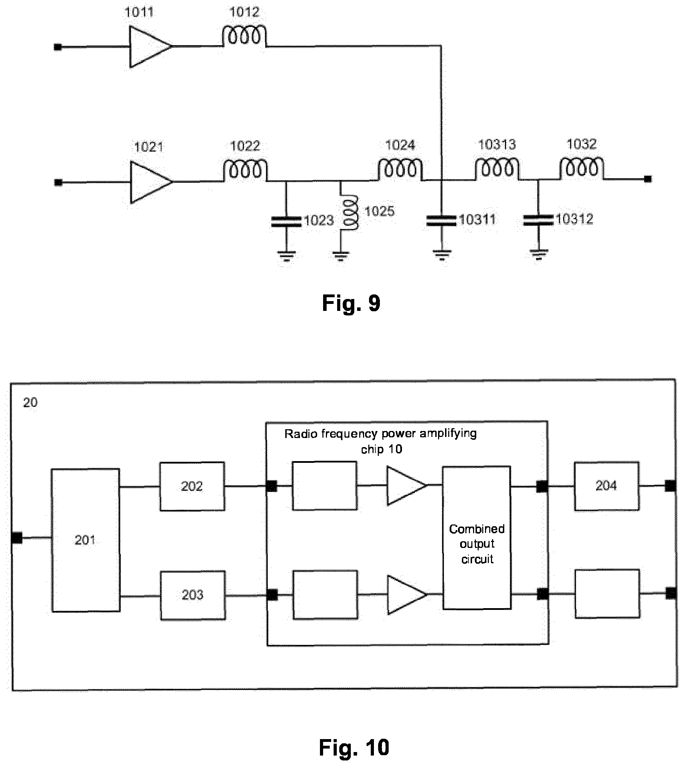

As shown in Fig. 9, Fig. 9 is an equivalent circuit schematic of Fig. 8. Different from Fig. 5, an inductor (about 0.2 to 0.8 nH) corresponding to the first bonding wire 1032, a first sub-capacitor 10311 (about 4 to 8 pF), a second sub-capacitor 10312 (about 4 to 8 pF), and an inductor (about 0.1 to 0.5 nH, depending on different design scenarios, frequencies, and semiconductor process types) corresponding to the second bonding wire 10313 are added in Fig. 9. The rest is the same as Fig. 5 and will not be repeated here.

In the embodiments corresponding to Figs.6 and 8, the first inductor 1012, the second inductor 1022, and the third inductor 1024 can be implemented in the form of metal bonding wires, and the first inductor 1012, the second inductor 1022, and the third inductor 1024 have the same direction, that is, the first inductor 1012, the second inductor 1022, and the third inductor 1024 are wired in the same direction, thereby reducing the mutual inductive coupling between the respective metal bonding wires and reducing the transmission loss of radio frequency signals.

In one or more embodiments, as shown in Figs. 4, 6, and 8, the radio frequency power amplifying chip 10 further comprises a first pin 1041. The first pin 1041 is connected to the second end of the fourth inductor 1025, and the first pin 1041 can also be connected to the drain voltage bias circuit. That is, the fourth inductor 1025 is connected to the drain voltage bias circuit through the first pin 1041 to supply voltages to the first amplifying branch 101 and the second amplifying branch 102.

In one or more embodiments, as shown in Figs. 6 and 8, the radio frequency power amplifying chip 10 further comprises a second pin 1042 and a third pin 1043. The second pin 1042 can be connected to the radio frequency output device to receive the radio frequency signal transmitted by the radio frequency output device, and the third pin 1043 can be connected to the radio frequency output device to receive the radio frequency signal transmitted by the radio frequency output device.

In the first amplifying branch 101, the first amplifying branch 101 further comprises a first transistor 1011 and a third capacitor 1051. The drain of the first transistor 1011 is connected to the first end of the first inductor 1012, the gate of the first transistor 1011 is connected to a second end of the third capacitor 1051, and a first end of the third capacitor 1051 is connected to the second pin 1042. The connection between the second pin 1042 and the third capacitor 1051, and the connection between the third capacitor 1051 and the first transistor 1011 can be in the form of a metal bonding wire.

In the second amplifying branch 102, the second amplifying branch 102 further comprises a second transistor 1021 and a fourth capacitor 1061. The drain of the second transistor 1021 is connected to a first end of the second inductor 1022, the gate of the second transistor 1021 is connected to a second end of the fourth capacitor 1061, and a first end of the fourth capacitor 1061 is connected to the third pin 1043. The connection between the third pin 1043 and the fourth capacitor 1061, and the connection between the fourth capacitor 1061 and the second transistor 1021 can be in the form of a metal bonding wire.

The radio frequency signal is input from the second pin 1042 to the third capacitor 1051 and the first transistor 1011. The third capacitor 1051 and the metal bonding wire connected thereto can assist in impedance matching at the input port. The radio frequency signal is input from the third pin 1043 to the fourth capacitor 1061 and the second transistor 1021. The fourth capacitor 1061 and the metal bonding wire connected thereto can assist in impedance matching at the input port. In some embodiments, the number of third capacitors 1051 can be multiple, the number of fourth capacitors 1061 can be multiple, the plurality of third capacitors 1051 connected in series, and the plurality of fourth capacitors 1061 connected in series. As shown in Fig. 4, the third capacitor 1051 comprises two, and the fourth capacitor 1061 comprises two.

In a case where the first inductor 1012, the second inductor 1022, and the third inductor 1024 are metal bonding wires, the length *l*₁ from the first transistor 1011 to the second capacitor 1031 can be from 1500 microns to 2800 microns, for example, 1700 microns, 2000 microns, 2400 microns, and 2700 microns. The length *l*₂ from the second transistor 1021 to the first capacitor 1023 can be 300 microns to 1000 microns, for example, 400 microns, 600 microns, 700 microns, and 900 microns. The length *l*₃ from the first capacitor 1023 to the second capacitor 1031 can be 500 microns to 1200 microns, for example, 600 microns, 700 microns, 900 microns, and 1000 microns. It should be noted that the specific length of the length *l*₁, length *l*₂ and length *l*₃ can be adjusted according to the actual situation.

It should be noted that the metal bonding wire can be realized by metals such as gold wire, copper wire, aluminum wire, and silver wire, and the capacitor can be realized in the form of silicon capacitor, ceramic capacitor, gallium arsenide GaAs IPD capacitor, etc.

The present disclosure also provides a radio frequency power amplifier, as shown in Fig. 10, Fig. 10 is a structural block diagram of the radio frequency power amplifier. The radio frequency power amplifier 20 comprises the aforementioned radio frequency power amplifying chip 10, a first input impedance matching circuit 202, a second input impedance matching circuit 203, and an output impedance matching circuit 204. One end of the first input impedance matching circuit 202 can be connected to the input port of the first amplifying branch 101 of the radio frequency power amplifying chip 10, and the other end of the first input impedance matching circuit 202 can be connected to the radio frequency output device (not shown). One end of the second input impedance matching circuit 203 can be connected to the input port of the second amplifying branch 102 of the radio frequency power amplifying chip 10, and the other end of the second input impedance matching circuit 203 can be connected to the radio frequency output device (not shown). That is, the first input impedance matching circuit 202 is connected to the input port of the first amplifying branch 101 of the radio frequency power amplifying chip 10, the radio frequency output device outputs the radio frequency signal through the first input impedance matching circuit 202 to the first amplifying branch 101, the second input impedance matching circuit 203 is connected to the input port of the second amplifying branch 102 of the radio frequency power amplifying chip 10, and the radio frequency output device outputs the radio frequency signal through the second input impedance matching circuit 203 to the second amplifying branch 102. The radio frequency power amplifier can be a Doherty amplifier.

The radio frequency power amplifier 20 employs the aforementioned radio frequency power amplifying chip 10. Since the radio frequency power amplifying chip 10 has the combined output circuit inside the chip, compared with the prior art which the radio frequency power amplifier has the combined output circuit placed on a PCB (printed circuit board), the present disclosure can reduce the size of the radio frequency power amplifier 20, to satisfy the requirement of miniaturization and integration of the radio frequency communication system.

One end of the output impedance matching circuit 204 is connected to the combined output circuit of the radio frequency power amplifying chip 10, and the other end of the output impedance matching circuit 204 is connected to the signal transmitting device. That is, one end of the output impedance matching circuit 204 is connected to the output port of the combined output circuit, and the other end of the output impedance matching circuit 204 is connected to the input port of the signal transmitting device. After the radio frequency signal is amplified through the first amplifying branch and the second amplifying branch, the radio frequency signal is respectively output to the output impedance matching circuit 204 through the combined output circuit, and output to the input port of the signal transmitting device through the output impedance matching circuit 204, and then the signal transmitting device transmits the signal to the user terminal.

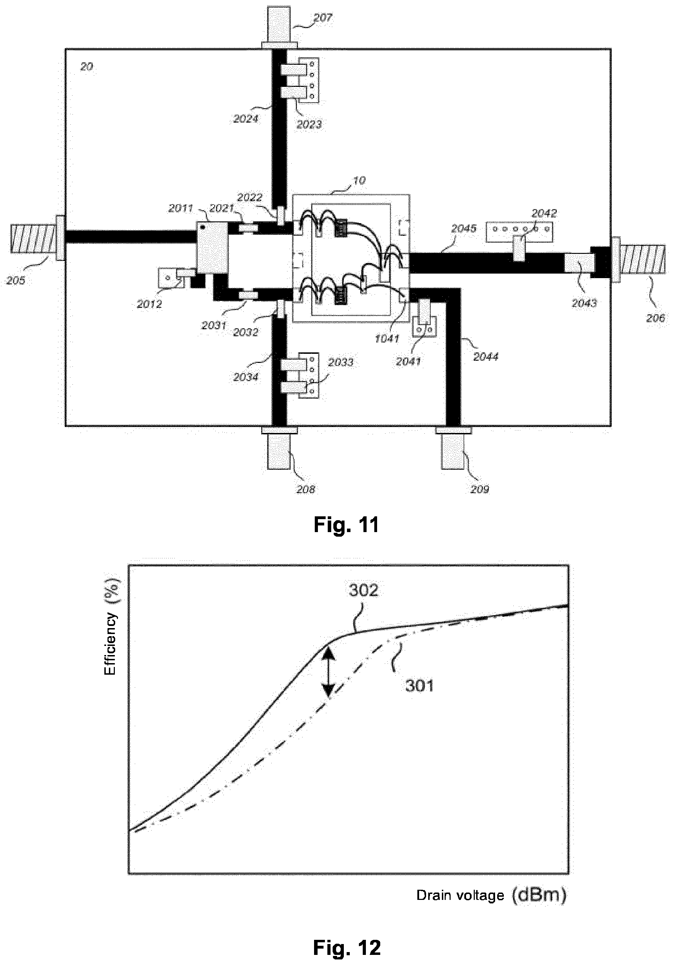

In one or more embodiments, the radio frequency power amplifier 20 can have a printed circuit board as a carrier, i.e., the radio frequency power amplifier 20 is formed on a printed circuit board. As shown in Fig. 11, Fig. 11 is a circuit schematic diagram of the radio frequency power amplifier. The first input impedance matching circuit 202 comprises a first DC-blocking capacitor 2021. The first end of the first DC-blocking capacitor 2021 can be connected to the radio frequency output device, and the second end of the first DC-blocking capacitor 2021 is connected to the input port of the first amplifying branch 101 of the radio frequency power amplifying chip 10. The second input impedance matching circuit 203 comprises a second DC-blocking capacitor 2031, the first end of the second DC-blocking capacitor 2031 can be connected to the radio frequency output device, and the second end of the second DC-blocking capacitor 2031 is connected to the input port of the second amplifying branch 102 of the radio frequency power amplifying chip 10. The first DC-blocking capacitor 2021 can be connected to the input port of the first amplifying branch 101 through the metal microstrip line, and the second DC-blocking capacitor 2031 can be connected to the input port of the second amplifying branch 102 through the metal microstrip line.

A through hole can be formed on the printed circuit board, and the output impedance matching circuit 204 comprises a fourth filter capacitor 2042, a fourth microstrip line 2045, and a third DC-blocking capacitor 2043. The first end of the third DC-blocking capacitor 2043 can be connected to the signal transmitting device (not shown), the second end of the second DC-blocking capacitor 2043 can be connected to one end of the fourth microstrip line 2045, the other end of the fourth microstrip line 2045 can be connected to the output port of the combined output circuit, the first end of the fourth filter capacitor 2042 can be connected to the fourth microstrip line 2045, and the second end of the fourth filter capacitor 2042 can be connected to the through hole. That is, the third DC-blocking capacitor 2043 is connected in series with the fourth microstrip line 2045, the first end of the fourth filter capacitor 2042 is connected to the fourth microstrip line 2045, and the second end of the fourth filter capacitor 2042 is grounded. In some embodiments, the radio frequency power amplifier 20 comprises a radio frequency output port 206. The third DC-blocking capacitor 2043 is connected to the signal transmitting device through the radio frequency output port 206.

The fourth filter capacitor 2042 can be multiple. The fourth filter capacitor 2042 is a grounded capacitor, and the radio frequency is equivalent to the ground, but the DC signal is not connected to the end, so as to provide a grounded path for the radio frequency signal, ensuring that subsequent circuit devices and DC voltage sources will not affect the operation of the radio frequency signal.

In one or more embodiments, as shown in Fig. 11, the radio frequency power amplifier 20 further comprises a first gate voltage bias circuit, a second gate voltage bias circuit, and a drain voltage bias circuit. One end of the first gate voltage bias circuit is connected to the input port of the first amplifying branch 101, and the other end of the first gate voltage bias circuit can be connected to a first power supply (not shown). That is, one end of the first gate voltage bias circuit is connected to the gate of the first transistor 1011 in the first amplifying branch 101, and the other end of the first gate voltage bias circuit is connected to the first power supply, and the first power supply supplies the gate voltage to the first transistor 1011 through the first gate voltage bias circuit.

The first gate voltage bias circuit can comprise a first filter capacitor 2023, a first microstrip line 2024, and a first feed inductor 2022. One end of the first microstrip line 2024 can be connected to the first power supply, the other end of the first microstrip line 2024 can be connected to the first end of the first feed inductor 2022, the second end of the first feed inductor 2022 can be connected to the input port of the first amplifying branch 101 (i.e., the gate of the first transistor 1011), the first end of the first filter capacitor 2023 is connected to the first microstrip line 2024, and the second end of the first filter capacitor 2023 is connected to ground (i.e., connected to the through hole and to be equivalent to be grounded). The radio frequency power amplifier 20 can also comprise a first voltage supply port 207 through which the first microstrip line 2024 is connected to the first power supply. In some embodiments, the first feed inductor 2022 can also be a resistor.

It should be noted that the first filter capacitor 2023 can be multiple, and in a case where the first filter capacitors 2023 are multiple, the plurality of the first filter capacitors 2023 are connected in parallel. The first filter capacitor 2023 is a grounded capacitor, and the radio frequency is equivalent to the ground, but the DC signal is not connected to the end, so as to provide a grounded path for the radio frequency signal, ensuring that subsequent circuit devices and DC voltage sources will not affect the operation of the radio frequency signal.

One end of the second gate voltage bias circuit is connected to the input port of the second amplifying branch 102, and the other end of the second gate voltage bias circuit can be connected to the second power supply (not shown). That is, one end of the second gate voltage bias circuit is connected to the gate of the second transistor 1021 in the second amplifying branch 102, and the other end of the second gate voltage bias circuit is connected to the second power supply, and the second power supply supplies the gate voltage to the second transistor through the second gate voltage bias circuit.

The second gate voltage bias circuit can comprise a second filter capacitor 2033, a second microstrip line 2034, and a second feed inductor 2032. One end of the second microstrip line 2034 can be connected to the second power source, the other end of the second microstrip line 2034 can be connected to the first end of the second feed inductor 2032, the second end of the second feed inductor 2032 can be connected to the input port of the second amplifying branch 102 (i.e., the gate of the second transistor 1021), the first end of the second filter capacitor 2033 is connected to the second microstrip line 2034, and the second end of the second filter capacitor 2033 is grounded (i.e., connected to the through hole and to be equivalent to be grounded). The radio frequency power amplifier 20 can also comprise a second voltage supply port 208 through which the second microstrip line 2034 is connected to the second power supply. In some embodiments, the second feed inductor 2032 can also be a resistor.

It should be noted that the second filter capacitor 2033 can be multiple, and in a case where the second filter capacitors 2033 are multiple, the plurality of second filter capacitors 2033 are connected in parallel. The second filter capacitor 2033 is a grounded capacitor, and the radio frequency is equivalent to the ground, but the DC signal is not connected to the end, so as to provide a grounded path for the radio frequency signal, ensuring that subsequent circuit devices and DC voltage sources will not affect the operation of the radio frequency signal.

The drain voltage bias circuit comprises a third filter capacitor 2041 and a third microstrip line 2044. One end of the third microstrip line 2044 is connected to the fourth inductor 1025 of the combined output circuit (i.e. connected to the first pin 1041), the other end of the third microstrip line 2044 is connected to a third power source (not shown), the first end of the third filter capacitor 2041 is connected to the third microstrip line 2044, and the second end of the third filter capacitor 2041 is grounded (i.e., connected to the through hole and to be equivalent to be grounded). The radio frequency power amplifier 20 can also comprise a third voltage supply port 209 through which the third microstrip line 2044 is connected to the third power supply.

It should be noted that the third filter capacitor 2041 can be multiple, and in a case where the third filter capacitors 2041 are multiple, the plurality of third filter capacitors 2041 are connected in parallel. The third filter capacitor 2041 is a grounded capacitor, and the radio frequency is equivalent to the ground, but the DC signal is not connected to the end, so as to provide a grounded path for the radio frequency signal, ensuring that subsequent circuit devices and DC voltage sources will not affect the operation of the radio frequency signal.

In one or more embodiments, as shown in Figs. 10 and 11, the radio frequency power amplifier 20 further comprises a power distribution circuit 201 comprising a resistor 2012 and a power distributor 2011. A first end of the power distributor 2011 is connected to the radio frequency output device, a second end of the power distributor 2011 is connected to the resistor 2012, a third end of the power distributor 2011 is connected to the input port of the first amplifying branch 101 (i.e., connected to the input port of the first amplifying branch 101 through the first input impedance matching circuit 202), and the third end of the power distributor 2011 is connected to the input port of the second amplifying branch 102 (i.e., connected to the input port of the second amplifying branch 103 through the second input impedance matching circuit 203). The radio frequency power amplifier 20 can also comprise a signal input 205 through which the first end of the power distributor 2011 is connected to the radio frequency output device. The signal output by the radio frequency output device is distributed to the first amplifying branch 101 and the second amplifying branch 102 through the power distributor 2011. The resistance value of the resistor 2012 comprises but is not limited to 50 ohms and 75 ohms.

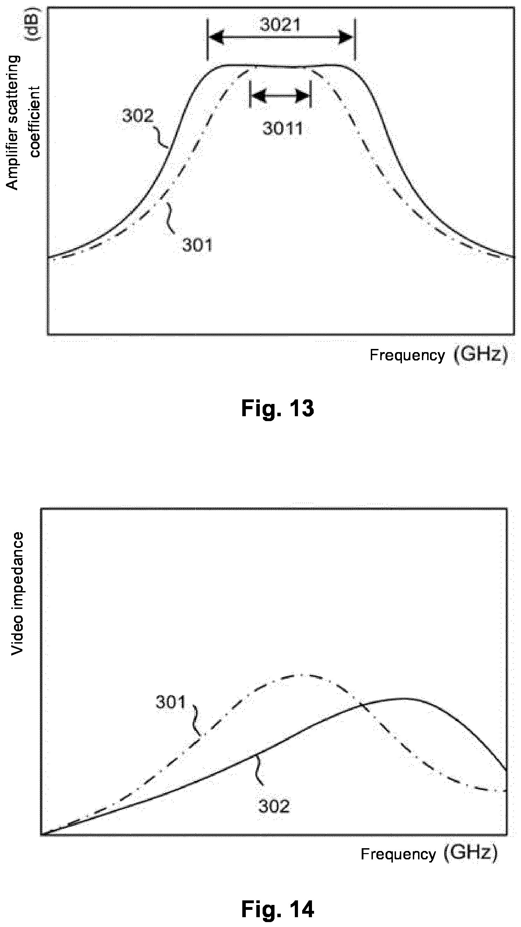

As shown in Figs. 12 and 13, Fig. 12 is an experimental comparison diagram of the technical proposal of the present disclosure and the technical proposal of the prior art, and Fig. 13 is another experimental comparison diagram of the technical proposal of the present disclosure and the technical proposal of the prior art. Fig. 14 is yet another experimental comparison diagram between the technical proposal of the present disclosure and the proposal of the prior art. Fig. 12 shows a comparison of operating efficiency, Fig. 13 shows a comparison of operating bandwidth, and Fig. 14 shows a comparison of video impedance.

In Fig. 12, Fig. 13, and Fig. 14, the first curve 301 is the experimental data of the proposal of the prior art, and the second curve 302 is the experimental data of the technical proposal of the present disclosure. By comparison, it can be seen that the technical proposal of the present disclosure can improve the operating efficiency when the drain voltage is reduced (fallback power state), and the operating efficiency is unchanged when the drain voltage is increased (saturation power state), so that the overall working efficiency of the radio frequency power amplifier is improved. It can also be seen that the second bandwidth 3021 corresponding to the technical proposal of the present disclosure is about twice as high as the first bandwidth 3011 corresponding to the proposal of the prior art. The lower the video impedance and the higher the frequency (video bandwidth) corresponding to peak of the video impedance, the better the baseband linearity of the radio frequency power amplifier. As can be seen from Fig. 14, the technical proposal has better linearity performance, and after digital pre-distortion (DPD) processing, the radio frequency signal has a better linearity characteristic.

The present disclosure also provides a wireless signal transmitting system comprising the aforementioned radio frequency power amplifier, the radio frequency output device (not shown), and the signal transmitting device (not shown). The radio frequency power amplifier is respectively connected to the radio frequency output device and the signal transmitting device. The radio frequency output device outputs the radio frequency signal to the radio frequency power amplifier. The radio frequency power amplifier amplifies the received signal and then outputs it to the signal transmitting device. The signal transmitting device transmits the signal to the user terminal.

Obviously, one skilled in the art can make various modifications and variations to the disclosure without departing from the spirit and scope of the disclosure. Thus, to the extent that these modifications and variations of the disclosure fall within the scope of the claims in the disclosure and their equivalent techniques, the disclosure is intended to comprise these modifications and variations as well.

## Claims

1. A radio frequency power amplifying chip (10), for a radio frequency power amplifier (20) for amplifying a signal, wherein the radio frequency power amplifier (20) comprises an output impedance matching circuit (204) and a drain voltage bias circuit, for connecting a radio frequency output device;
**characterized in that**, the radio frequency power amplifying chip (10) comprises a first amplifying branch (101) and a second amplifying branch (102), an input port of the first amplifying branch (101) and an input port of the second amplifying branch (102) are configured to receive a radio frequency signal from the radio frequency output device, and the radio frequency power amplifying chip (10) further comprises a combined output circuit comprising:
a first inductor (1012) having a first end connected to an output port of the first amplifying branch (101), and a second end connected to the output impedance matching circuit (204) of the radio frequency power amplifier (20);
a second inductor (1022) having a first end connected to an output port of the second amplifying branch (102);
a third inductor (1024) having a first end connected to a second end of the second inductor (1022), and a second end connected to the output impedance matching circuit (204) of the radio frequency power amplifier (20);
a first capacitor (1023) having a first end connected between a second end of the second inductor and the first end of the third inductor, and a second end grounded; and
a fourth inductor (1025) having a first end connected to the first end of the first capacitor (1023), and a second end connected to the drain voltage bias circuit of the radio frequency power amplifier (20).

2. The radio frequency power amplifying chip (10) according to claim 1, wherein the second inductor (1022) and the third inductor (1024) are metal bonded wires having the same wiring direction.

3. The radio frequency power amplifying chip (10) according to claim 1, wherein the combined output circuit further comprises:
a second capacitor (1031) having a first end connected to the second end of the first inductor (1012) and the second end of the third inductor (1024) respectively, and a second end connected to the output impedance matching circuit (204) of the radio frequency power amplifier (20).

4. The radio frequency power amplifying chip (10) according to claim 3, wherein the second capacitor (1031) is a double-splicing capacitor comprising:
a first sub-capacitor (10311) having a first end connected to the second end of the first inductor (1012) and the second end of the third inductor (1024) respectively;
a second sub-capacitor (10312) having a first end connected to a second end of the first sub-capacitor (10311), and a second end connected to the output impedance matching circuit (204) of the radio frequency power amplifier (20).

5. The radio frequency power amplifying chip (10) according to claim 3 or 4, wherein the first inductor (1012), the second inductor (1022), and the third inductor (1024) are metal bonded wires having the same wiring direction.

6. The radio frequency power amplifying chip (10) according to any one of claims 1 to 4, further comprising:
a first pin (1041) connected to the second end of the fourth inductor (1025), and further connected to the drain voltage bias circuit; or,
a fourth pin (1044), the second pin being connected to the second end of the first inductor (1012) and the second end of the third inductor (1024) respectively, and the fourth pin (1044) being further connected to the output impedance matching circuit (204).

7. The radio frequency power amplifying chip (10) according to any one of claims 1 to 4, wherein the radio frequency power amplifying chip (10) further comprises a second pin (1042) for connecting the radio frequency output device, and the first amplifying branch (101) further comprises:
a first transistor (1011) having a drain connected to the first end of the first inductor (1012);
a third capacitor (1051) having a first end connected to the second pin (1042) and a second end connected to a gate of the first transistor (1011);
or
wherein the radio frequency power amplifying chip (10) further comprises a third pin (1043) for connecting the radio frequency output device, and the second amplifying branch (102) further comprises:
a second transistor (1021) having a drain connected to the first end of the second inductor (1022);
a fourth capacitor (1061) having a first end connected to the third pin (1043) and a second end connected to a gate of the second transistor (1021).

8. A radio frequency power amplifier (20), comprising:
the radio frequency power amplifying chip (10) according to any one of claims 1 to 7;
a first input impedance matching circuit (202) having one end connected to the input port of the first amplifying branch (101) of the radio frequency power amplifying chip (10), and the other end connected to the radio frequency output device;
a second input impedance matching circuit (203) having one end connected to the input port of the second amplifying branch (102) of the radio frequency power amplifying chip (10), and the other end connected to the radio frequency output device;
an output impedance matching circuit (204) having one end connected to a combined output circuit of the radio frequency power amplifying chip (10), and the other end connected to a signal transmitting device; and
a drain voltage bias circuit having one end connected to the fourth inductor (1025) of the combined output circuit, and the other end connected to a third power supply.

9. The radio frequency power amplifier (20) according to claim 8, further comprising:
a first gate voltage bias circuit having one end connected to the input port of the first amplifying branch (101), and the other end connected to a first power supply; and
a second gate voltage bias circuit having one end connected to the input port of the second amplifying branch (102), and the other end connected to a second power supply.

10. The radio frequency power amplifier (20) according to claim 8, wherein the radio frequency power amplifier (20) further comprises a power distribution circuit (201) comprising:
a resistor (2012);
a power distributor (2011) having a first end connected to the radio frequency output device, a second end connected to the resistor (2012), a third end connected to the input port of the first amplifying branch (101), and a fourth end connected to the input port of the second amplifying branch (102).

11. A wireless signal transmitting system comprising:
a radio frequency output device;
a signal transmitting device; and
the radio frequency power amplifier (20) according to any one of claims 8 to 10, wherein the radio frequency power amplifier (20) is connected to the radio frequency output device and the signal transmitting device respectively.
